# EUROPEAN PATENT APPLICATION

(11) **EP 2 602 732 A1**
(43) Date of publication of application: **12.06.2013**
(21) Application number: 12194796.4
(22) Date of filing: 29.11.2012
(51) Int. Cl.: G06F 17/50, G06Q 10/00

(54) **System and method for assessing future power plant capabilities**

(30) Priority: 07.12.2011 US 201113313671
(71) Applicant: General Electric Company, Schenectady, New York 12345 (US)
(72) Inventor: Schroder, Mark S., Greenville, SC South Carolina 29615 (US); Johnson, Scott, Greenville, SC South Carolina 29615 (US); O'Connor, Michael, Greenville, SC South Carolina 29615 (US)
(74) Representative: Williams, Andrew Richard

(57) **Abstract**

Embodiments of the invention can provide systems and methods for assessing future power plant capabilities. In one embodiment, a method may be provided, the method comprising: receiving one or more power plant historic operation parameters; receiving one or more power plant intrinsic performance capabilities based at least in part on an as-built configuration; receiving at least one client input; receiving at least one power plant performance model based at least in part on the one or more performance parameters of similar power plants or the one or more power plant historic operation parameters; and outputting via a user interface at least one dataset of the power plant capabilities in the future.

## Description

### FIELD OF THE INVENTION

Embodiments of the invention relate generally to power plants, and more particularly to systems and methods for assessing future power plant capabilities.

### BACKGROUND OF THE INVENTION

Power plant operators and/or electricity market traders routinely assess power plant operation costs to accurately forecast production costs. In particular, the ability to accurately assess power plant capabilities in the future enables power plant operators and/or electricity market traders to minimize costs and maximize electricity revenue.

### BRIEF DESCRIPTION OF THE INVENTION

Some or all of the above needs and/or problems may be addressed by certain embodiments of the invention. Disclosed embodiments may include systems and methods for assessing future power plant capabilities. According to one embodiment of the invention, there is disclosed a method for assessing future power plant capabilities. The method can include receiving one or more power plant historic operation parameters; receiving one or more power plant intrinsic performance capabilities based at least in part on an as-built configuration; receiving at least one client input; receiving at least one power plant performance model based at least in part on the one or more performance parameters of similar power plants or the one or more power plant historic operation parameters; and outputting via a user interface at least one dataset of the power plant capabilities in the future, wherein the at least one dataset of the power plant capabilities in the future is based at least in part on the one or more power plant historic operation parameters, the one or more power plant intrinsic performance capabilities, the at least one client input, and the at least one power plant performance model.

According to another embodiment of the invention, there is disclosed a system for assessing future power plant capabilities. The system can include a computer processor; a user interface in communication with the computer processor; and a memory in communication with the computer processor operable to store computer-executable instructions operable to: receive one or more power plant historic operation parameters; receive one or more power plant intrinsic performance capabilities based at least in part on an as-built configuration; receive at least one client input; receive at least one power plant performance model based at least in part on one or more performance parameters of similar power plants or the one or more power plant historic operation parameters; and output via the user interface at least one dataset of the power plant capabilities in the future, wherein the at least one dataset of the power plant capabilities in the future is based at least in part on the one or more power plant historic operation parameters, the one or more power plant intrinsic performance capabilities, the at least one client input, and the at least one power plant performance model.

Further, according to another embodiment of the invention, there is disclosed an apparatus for assessing future power plant capabilities. The apparatus can include a processor operable to store computer-executable instructions; a power plant assessment module comprising computer-executable instructions operable to: store one or more power plant historic operation parameters; store one or more power plant intrinsic performance capabilities based at least in part on an as-built configuration; store at least one client input; receive at least one power plant performance model based at least in part on one or more performance parameters of similar power plants or the one or more power plant historic operation parameters; and output power plant capabilities in the future based at least in part on the one or more power plant historic operation parameters, the one or more power plant intrinsic performance capabilities, the at least one client input, and the at least one power plant performance model.

Other embodiments, aspects, and features of the invention will become apparent to those skilled in the art from the following detailed description, the accompanying drawings, and the appended claims.

### BRIEF DESCRIPTION OF THE DRAWINGS

Reference will now be made to the accompanying drawings, which are not necessarily drawn to scale, and wherein:
FIG. 1 is an example graph illustrating details of at least one dataset for assessing future power plant capabilities, according to an embodiment of the invention.
FIG. 2 is a schematic illustrating details of an example data flow for assessing future power plant capabilities, according to an embodiment of the invention.
FIG 3 is a schematic illustrating details of an example data flow including a block diagram of a computer environment for assessing future power plant capabilities, according to an embodiment of the invention.
FIG. 4 is a flow diagram illustrating details of an example method for assessing future power plant capabilities, according to an embodiment of the invention.

### DETAILED DESCRIPTION OF THE INVENTION

Illustrative embodiments of the invention will now be described more fully hereinafter with reference to the accompanying drawings, in which some, but not all embodiments of the invention are shown. The invention may be embodied in many different forms and should not be construed as limited to the embodiments set forth herein; rather, these embodiments are provided so that this disclosure will satisfy applicable legal requirements. Like numbers refer to like elements throughout.

Illustrative embodiments of the invention are directed to, among other things, systems and methods for assessing future power plant capabilities. Certain illustrative embodiments of the invention may be directed to outputting at least one dataset of power plant capabilities in the future based at least in part on one or more power plant historic operation parameters, one or more power plant intrinsic performance capabilities, at least one client input, and at least one power plant performance model. Moreover, in certain embodiments, the at least one dataset of the power plant capabilities in the future may be adjusted based on at least one of the following: a client input of specific nature, an expected range of temperatures in the future, historic operational references of the power plant, maintenance planned for the power plant in the future, or existing or planned available power plant performance enhancements.

In some embodiments, the one or more power plant historic operation parameters may comprise at least one of the following: ambient temperature and humidity, generator output of electrical energy, a fuel flow, a combustion exhaust temperature, a steam input flow, a steam output flow, a condenser pressure, a steam generator drum pressure and temperature, a stack exit temperature, any collection of power plant auxiliary load(s), or an output from instrumentation installed at any location within the power plant. In other embodiments, the one or more power plant intrinsic capabilities may comprise at least one of the following: a power plant overall output of electrical energy, or a heat rate or ratio of thermal energy brought into the power plant over the electrical energy generated by the power plant over the same range of capable operation. In still other embodiments, the at least one client input may comprise at least one of the following: a fuel price, an emission cost, a variable operation and maintenance cost, a startup cost impact, a fixed operation and maintenance cost, or a desired bid adder, or any other desired client input that may be related to any cost within the power plant. Further, in some embodiments, the one or more performance parameters of the at least one performance model may comprise at least one of the following: a load, a demand or requested plant electrical energy generation, an ambient condition of pressure, humidity, or temperature, an overall power plant heat rate, or an overall power plant energy power output or electrical energy. Certain embodiments of the invention can provide a technical solution to assessing future power plant capabilities. In one embodiment, at least one dataset of power plant capabilities in the future is generated based at least in part on one or more power plant historic operation parameters, one or more power plant intrinsic performance capabilities, at least one client input, and at least one power plant performance model. In this manner, certain embodiments of the invention may provide production cost forecasts for assessing power plant capabilities in the future. In particular, certain embodiments of the invention can provide power plant operators and electricity market traders with forecasted power plant operation costs and future upgrade options to facilitate minimizing costs and maximizing electricity revenue in the future.

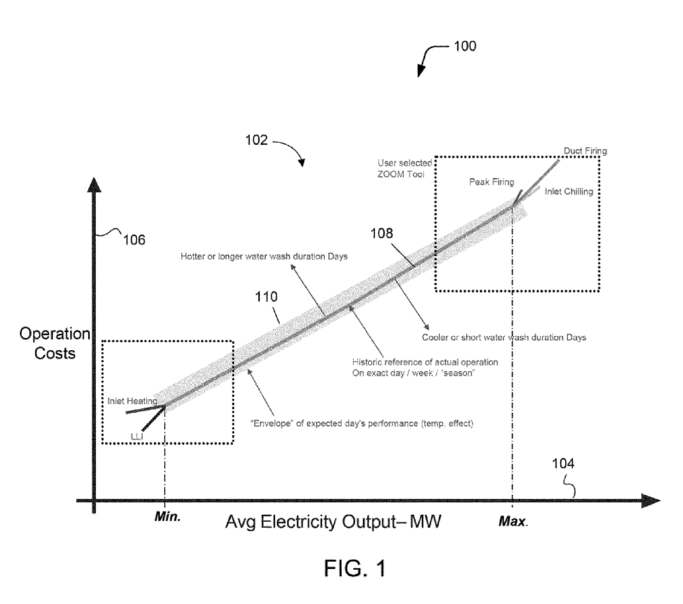

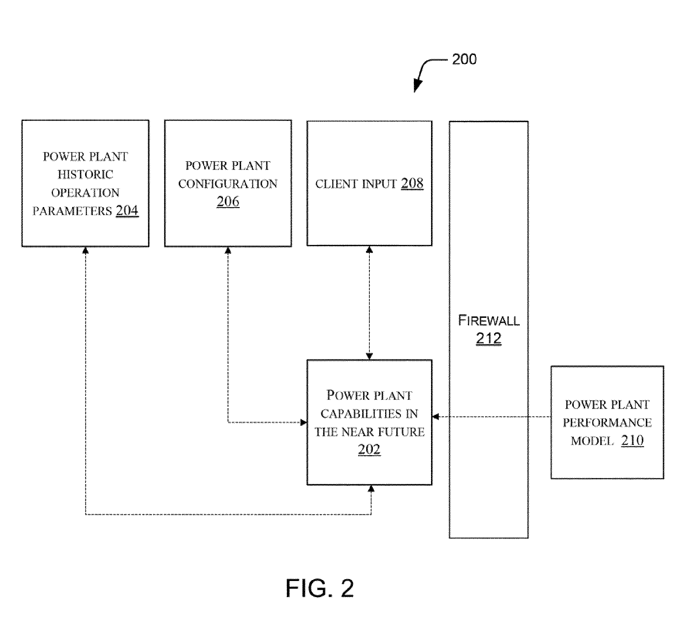

FIG. 1 provides an example graph 100 illustrating details of at least one dataset 102 for assessing power plant capabilities in the future. The graph 100 shown in FIG. 1 can be generated by the data flow 200, system 300, and/or process 400 shown in respective FIGs. 2, 3, and 4. The x-axis 104 in FIG. 1 is the average electricity output in megawatts in the future. The y-axis 106 is the operation costs at each electrical output level of the power plant in the future. The dataset 102 can include a line 108 referencing the expected performance of the power plant in the future based at least in part on historical references and/or a performance model. For example, if historical references are not yet available, the line 108 may comprise a performance model of expected operation costs versus electricity output based on the type and/or configuration of the power plant. If historical operation references are available, the line 108 may be based on the historical operation of the power plant on a past date and time. That is, the line 108 may be based on the historic operation of the power plant during any given time frame in the past, such as, but not limited to, a day, a week, a year, or any other prior time reference. Moreover, in certain embodiments, the line 108 may be based on both historical references and a performance model. In such embodiments, the performance model may fill gaps in information relating to the historical references.

Still referring to FIG. 1, the dataset 102 can also include an envelope 110 about the line 108 forming, for example, Bollinger Bands or other adaptive trading bands. The envelope 110 can be based on the expected range of temperatures in the future. For example, depending on the range of temperatures in the future, the envelope 110 may deviate from the line 108. The line 108 can be adjusted within the envelope 110 based at least in part on existing and available power plant performance enhancements, such as, but not limited to, inlet chilling and/or heating, duct firing, and/or peak firing. Moreover, the line 108 can be adjusted within the envelope 110 based at least in part on the effects of scheduled maintenance in the future, such as, but not limited to, water wash duration and/or ambient conditions, including, but not limited to, temperature, pressure, and/or humidity.

The graphical output of FIG. 1 can be used by power plant operators and/or electricity market traders to assess power plant operation costs in the future, including, but not limited to, the next hour, day, month, year, or any other desired time frame. The graphical output of FIG. 1 can also be used by power plant operators and/or electricity market traders to determine any desirable future power plant performance enhancements and upgrade options and to schedule maintenance accordingly to minimize costs and maximize electricity revenue in the future. The graphical output of FIG. 1 is an example embodiment of an output format; one will appreciated, however, that any type of output format may be implemented; for example, the graphical output of FIG. 1 may also be expressed as a spreadsheet or any other expressible medium.

FIG. 2 provides a data flow 200 for assessing power plant capabilities in the future. The data flow 200 can include the resulting power plant capabilities in the future block 202. The power plant capabilities in the future block 202 is a platform for receiving and exchanging information related to power plant historic operation parameters 204, power plant configuration 206, client input 208, and power plant performance model 210. Power plant capabilities in the future block 202 compiles the information received into a dataset. The dataset can be displayed graphically as in FIG. 1 and can be used to assess power plant capabilities in the future discussed above.

Power plant historic operation parameters block 204 can include data related to, but not limited to, generator output of combined power plant level electrical energy, a fuel flow(s), a combustion exhaust temperature(s), a steam input flow(s), a steam output flow(s), a condenser pressure(s), a steam generator drum pressure(s) and temperature(s), a stack exit temperature(s), or any collection of power plant auxiliary load(s). One will appreciate that the power plant historic operation parameters block 204 can include any output from existing, planned, or specifically added instrumentation installed at any location within the power plant. The data from the power plant historic operation parameters block 204 may be used to create at least a portion of the line 108 referencing the expected performance of the power plant in the future discussed above in FIG. 1. The data from the power plant historic operation parameters block 204 may also be used to calibrate a performance model as discussed below.

Power plant configuration block 206 can include one or more power plant intrinsic performance capabilities based at least in part on an as-built configuration of the power plant. For example, the intrinsic performance capabilities can include, but are not limited to, a power plant overall output of electrical energy, a heat rate, or a ratio of thermal energy brought into the power plant over the electrical energy generated by the power plant over the same range of capable operation. The data from the power plant configuration block 206 can be used to create at least a portion of the line 108 referencing the expected performance of the power plant in the future discussed above in FIG. 1.

Client input block 208 can include information relating to, but not limited to, a fuel price, an emission cost, a variable operation and maintenance cost, a startup cost impact, a fixed operation and maintenance cost, a desired bid adder, or any other desired client input that is related to any cost within the power plant. The data from the client input block 208 can be used to adjust the scale of at least a portion of the dataset 102 of the power plant in the future discussed above in FIG. 1. For example, if the price of fuel increases, the dataset 102 may be adjusted to reflect the increased cost in fuel.

The power plant performance model block 210 can include a performance model based at least in part on one or more performance parameters of similar power plants or the one or more power plant historic operation parameters 204. The performance model is used as the baseline to create the line 108 in FIG. 1. As additional power plant historic operation parameters become available, the performance model may be updated and adjusted to account for past power plant performance. In certain embodiments, if a sufficient amount of information relating to the power plant historic operation parameters is available to independently create the line 108 in FIG. 1, the performance model may not be needed. In other embodiments, the performance model may be used to fill gaps in data related to the power plant historic operation parameters to create the line 108 in FIG. 1. In some aspects, equipment manufacturer proprietary information may be included in calculating the performance model. In such instances, a firewall 212 may prevent the two-way exchange of proprietary information between the power plant performance model block 210 and the power plant capabilities in the future block 202.

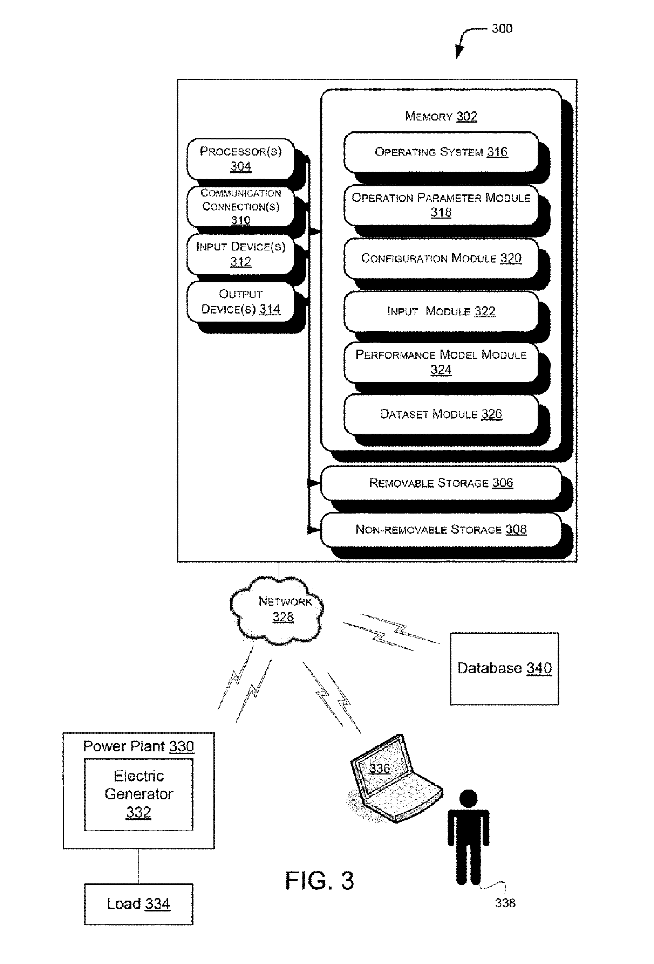

FIG. 3 provides an illustrative overview of a system, including one computing device 300, for assessing power plant capabilities in the future, according to an embodiment of the invention. The computing device 300 may be configured as any suitable computing device capable of implementing the disclosed features, and accompanying methods, such as, but not limited to, those described with reference to FIG. 3. By way of example and not limitation, suitable computing devices may include personal computers (PCs), servers, server farms, data centers, or any other device capable of storing and executing all or part of the disclosed features.

In one illustrative configuration, the computing device 300 comprises at least a memory 302 and one or more processing units (or processor(s)) 304. The processor(s) 304 may be implemented as appropriate in hardware, software, firmware, or combinations thereof. Software or firmware implementations of the processor(s) 304 may include computer-executable or machine-executable instructions written in any suitable programming language to perform the various functions described.

Memory 302 may store program instructions that are loadable and executable on the processor(s) 304, as well as data generated during the execution of these programs. Depending on the configuration and type of computing device 300, memory 302 may be volatile (such as random access memory (RAM)) and/or non-volatile (such as read-only memory (ROM), flash memory, etc.). The computing device or server may also include additional removable storage 306 and/or non-removable storage 308 including, but not limited to, magnetic storage, optical disks, and/or tape storage. The disk drives and their associated computer-readable media may provide non-volatile storage of computer-readable instructions, data structures, program modules, and other data for the computing devices. In some implementations, the memory 302 may include multiple different types of memory, such as static random access memory (SRAM), dynamic random access memory (DRAM), or ROM.

Memory 302, removable storage 306, and non-removable storage 308 are all examples of computer-readable storage media. For example, computer-readable storage media may include volatile and non-volatile, removable and non-removable media implemented in any method or technology for storage of information such as computer-readable instructions, data structures, program modules or other data. Memory 302, removable storage 306, and non-removable storage 308 are all examples of computer storage media. Additional types of computer storage media that may be present include, but are not limited to, programmable random access memory (PRAM), SRAM, DRAM, RAM, ROM, electrically erasable programmable read-only memory (EEPROM), flash memory or other memory technology, compact disc read-only memory (CD-ROM), digital versatile discs (DVD) or other optical storage, magnetic cassettes, magnetic tape, magnetic disk storage or other magnetic storage devices, or any other medium which can be used to store the desired information and which can be accessed by the server or other computing device. Combinations of any of above should also be included within the scope of computer-readable media.

Alternatively, computer-readable communication media may include computer-readable instructions, program modules, or other data transmitted within a data signal, such as a carrier wave, or other transmission.

The computing device 300 may also contain communication connection(s) 310 that allow the computing device 300 to communicate with a stored database, another computing device or server, user terminals, and/or other devices on a network 328. The computing device 300 may also include input device(s) 312 such as a keyboard, mouse, pen, voice input device, touch input device, etc., and output device(s) 314, such as a display, speakers, printer, etc.

Turning to the contents of the memory 302 in more detail, the memory 302 may include an operating system 316 and one or more application programs or services for implementing the features disclosed herein including an operation parameter module 318. The operation parameter module 318 may be configured to receive one or more power plant historic operation parameters. Additionally, the operation parameter module 318 may store the one or more power plant historic operation parameters in the memory 302. An example power plant historic operation parameter can be, but is not limited to, at least one of the following: generator output, a fuel flow, an exhaust temperature, a steam input flow, a steam output flow, a condenser pressure, a drum pressure and temperature, a stack exit temperature, an auxiliary load, or an output from instrumentation of the power plant. In some aspects, the one or more power plant historic operation parameters are used to predict a future operating state of the power plant. In other aspects, the one or more power plant historic operation parameters are used to calibrate at least one power plant performance model to predict a future operating state of the power plant as discussed below in performance model module 324.

The memory 302 may further include a configuration module 320. The configuration module 320 may be configured to receive one or more power plant intrinsic capabilities based at least in part on an as-built configuration. Additionally, the configuration module 320 may store one or more power plant intrinsic capabilities based at least in part on an as-built configuration in the memory 302. An example of one or more power plant intrinsic capabilities can be, but is not limited to, at least one of a power plant overall output of electrical energy, a heat rate, or a ratio of thermal energy brought into the power plant over the electrical energy generated by the power plant over the same range of capable operation. The configuration module 320 can be used to create at least a portion of a dataset referencing the expected performance of the power plant in the future in dataset module 326 discussed below.

The memory 302 may also include an input module 322. The input module 322 may be configured to receive at least one client input. The client input can include, but is not limited to, at least one of a fuel price, an emission cost, a variable operation and maintenance cost, a startup cost impact, a fixed operation and maintenance cost, a desired bid adder, or any other desired client input that is related to any cost within the power plant. The client input module 322 can be used to adjust the scale of at least a portion of the dataset in dataset module 326 discussed below. For example, if the price of fuel increases, the dataset may be adjusted to reflect the increased cost in fuel.

The memory 302 may also include a performance model module 324. The performance model module 324 may be configured to receive at least one power plant performance model based at least in part on one or more performance parameters of similar power plants or the one or more power plant historic operation parameters. The performance model module 324 can include a performance model based at least in part on one or more performance parameters of similar power plants or the one or more power plant historic operation parameters 204. The performance model is used as the baseline to create the dataset in dataset module 326 discussed below. As additional power plant historic operation parameters become available, the performance model may be updated and adjusted. In certain embodiments, if a sufficient amount of information relating to the power plant historic operation parameters is available to independently create the dataset in dataset module 326 discussed below, the performance model may not be needed. In other embodiments, the performance model may be used to fill gaps in the dataset related to the power plant historic operation parameters to create a complete dataset in dataset module 326 discussed below.

The memory 302 may also include a dataset module 326. The dataset module 326 may be configured to output at least one dataset of the power plant capabilities in the future based at least in part on the one or more power plant historic operation parameters, the one or more power plant intrinsic capabilities, the at least one client input, and the at least one power plant performance model. In certain embodiments, the dataset can include a graph as discussed above in FIG. 1. In some aspects, the dataset may be adjusted based at least in part on an expected range of temperatures in the future. In other aspects, the dataset can be adjusted based at least in part on existing and available power plant performance enhancements or on the effects of scheduled maintenance in the future.

Various instructions, methods and techniques described herein may be considered in the general context of computer-executable instructions, such as program modules, executed by one or more computers or other devices. Generally, program modules include routines, programs, objects, components, data structures, etc., for performing particular tasks or implementing particular abstract data types. These program modules and the like may be executed as native code or may be downloaded and executed, such as in a virtual machine or other just-in-time compilation execution environment. Typically, the functionality of the program modules may be combined or distributed as desired in various embodiments. An implementation of these modules and techniques may be stored on some form of computer-readable storage media.

The example computing device 300 shown in FIG. 3 is provided by way of example only. Numerous other operating environments, system architectures, and device configurations are possible. Accordingly, embodiments of the present disclosure should not be construed as being limited to any particular operating environment, system architecture, or device configuration.

Still referring to FIG. 3, by way of example, the computing device 300 can be in communication with a power plant 330 via a network 328. The power plant 330 may include an electric generator 332 or other means or devices for generating power. The power plant 330 may generate power to meet, satisfy, or otherwise supply a load 334. Certain illustrative embodiments of the invention may be directed towards the computing device 300 outputting at least one dataset of power plant 330 capabilities in the future based at least in part on the one or more power plant historic operation parameters, the one or more power plant intrinsic capabilities, the at least one client input, and the at least one power plant performance model. The dataset of power plant 330 capabilities in the future can be presented as the graphical output 100 shown in, for example, FIG. 1, on client device 336. A user 338, such as power plant operators and/or electricity market traders, may access the computing device 300 remotely via the network 328 and client device 336. Information relating to the power plant 330 and/or the computing device 300 can be stored and accessed in a database 340.

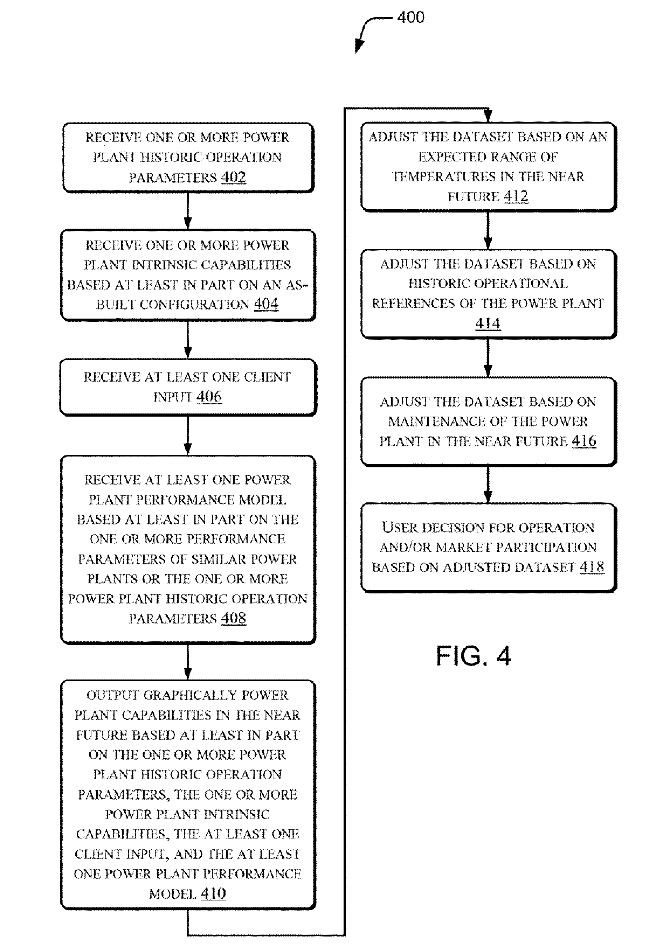

FIG. 4 illustrates an example flow diagram of a method 400 for assessing power plant capabilities in the future, according to an embodiment of the invention. In one example, the illustrative computing device 300 of FIG. 3 and/or one or more modules of the illustrative computing device 300, alone or in combination, may perform the described operations of method 400.

In this particular implementation, the method 400 may begin at block 402 of FIG. 4 in which the method 400 may include receiving one or more power plant historic operation parameters. Further, at block 404, the method 400 may include receiving one or more power plant intrinsic capabilities based at least in part on an as-built configuration. At block 406, the method 400 may include receiving at least one client input. At block 408, the method 400 may include receiving at least one power plant performance model based at least in part on the one or more performance parameters of similar power plants or the one or more power plant historic operation parameters. Moreover, at block 410, the method 400 may include outputting via a graphical user interface at least one dataset of the power plant capabilities in the future based at least in part on the one or more power plant historic operation parameters, the one or more power plant intrinsic capabilities, the at least one client input, and the at least one power plant performance model. For example, a dataset similar to the data shown in graph 100 of FIG. 1 can be output via the method 400.

At block 412, the method 400 may include adjusting the at least one dataset of the power plant capabilities in the future based on an expected range of temperatures in the future. At block 414, the method 400 may include adjusting the at least one dataset of the power plant capabilities in the future based on historic operational references of the power plant. At block 416, the method 400 may include adjusting the at least one dataset of the power plant capabilities in the future based on maintenance of the power plant in the future. At block 418, the method 400 may include a user decision criteria and/or customized reports to make various economic and/or operational decisions by the user.

Illustrative systems and methods are described for assessing power plant capabilities in the future. Some or all of these systems and methods may, but need not, be implemented at least partially by architectures such as those shown in FIG. 3 above.

Although embodiments have been described in language specific to structural features and/or methodological acts, it is to be understood that the disclosure is not necessarily limited to the specific features or acts described. Rather, the specific features and acts are disclosed as illustrative forms of implementing the embodiments.

Various aspects and embodiments of the invention are discloses in the following clauses:
1. A system for assessing future power plant capabilities, comprising:
   a computer processor;
   a user interface in communication with the computer processor; and
   a memory in communication with the computer processor operable to store computer-executable instructions operable to:
      receive one or more power plant historic operation parameters;
      receive one or more power plant intrinsic performance capabilities based at least in part on an as-built configuration;
      receive at least one client input;
      receive at least one power plant performance model based at least in part on one or more performance parameters of similar power plants or the one or more power plant historic operation parameters; and
      output via the user interface at least one dataset of the power plant capabilities in the future, wherein the at least one dataset of the power plant capabilities in the future is based at least in part on the one or more power plant historic operation parameters, the one or more power plant intrinsic performance capabilities, the at least one client input, and the at least one power plant performance model.
2. The system of Clause 1, wherein the at least one dataset of the power plant capabilities in the future is adjusted based on at least one of the following: an expected range of temperatures in the future, historic operational references of the power plant, maintenance planned for the power plant in the future, or existing or available power plant performance enhancements.
3. The system of Clause 1, wherein the one or more power plant historic operation parameters comprise at least one of the following: generator output of electrical energy, a fuel flow, a combustion exhaust temperature, a steam input flow, a steam output flow, a condenser pressure, a steam generator drum pressure and temperature, a stack exit temperature, any collection of power plant auxiliary load(s), or an output from instrumentation installed at any location within the power plant.
4. The system of Clause 1, wherein the one or more power plant intrinsic capabilities comprise at least one of the following: a power plant overall output of electrical energy, or a heat rate or ratio of thermal energy brought into the power plant over the electrical energy generated by the power plant over the same range of capable operation.
5. The system of Clause 1, wherein the at least one client input comprises at least one of the following: a fuel price, an emission cost, a variable operation and maintenance cost, a startup cost impact, a fixed operation and maintenance cost, or a desired bid adder, or any other desired client input that may be related to any cost within the power plant.
6. The system of Clause 1, wherein the one or more performance parameters of the at least one performance model comprise at least one of the following: a load, a demand or requested plant electrical energy generation, an ambient condition of pressure or temperature, an overall power plant heat rate, or an overall power plant energy power output or electrical energy.
7. The system of Clause 1, wherein the at least one dataset of the power plant capabilities in the future is displayed in graphical form or format.
8. A method for assessing future power plant capabilities, the method comprising:
   receiving one or more power plant historic operation parameters;
   receiving one or more power plant intrinsic performance capabilities based at least in part on an as-built configuration;
   receiving at least one client input;
   receiving at least one power plant performance model based at least in part on the one or more performance parameters of similar power plants or the one or more power plant historic operation parameters; and
   outputting via a user interface at least one dataset of the power plant capabilities in the future, wherein the at least one dataset of the power plant capabilities in the future is based at least in part on the one or more power plant historic operation parameters, the one or more power plant intrinsic performance capabilities, the at least one client input, and the at least one power plant performance model.
9. The method of Clause 8, wherein the at least one dataset of the power plant capabilities in the future is adjusted based on at least one of the following: an expected range of temperatures in the future, historic operational references of the power plant, maintenance planned for the power plant in the future, or existing or available power plant performance enhancements.
10. The method of Clause 8, wherein the one or more power plant historic operation parameters comprise at least one of the following: generator output of electrical energy, a fuel flow, a combustion exhaust temperature, a steam input flow, a steam output flow, a condenser pressure, a steam generator drum pressure and temperature, a stack exit temperature, any collection of power plant auxiliary load(s), or an output from instrumentation installed at any location within the power plant.
11. The method of Clause 8, wherein the one or more power plant intrinsic capabilities comprise at least one of the following: a power plant overall output of electrical energy, or a heat rate or ratio of thermal energy brought into the power plant over the electrical energy generated by the power plant over the same range of capable operation.
12. The method of Clause 8, wherein the at least one client input comprises at least one of the following: a fuel price, an emission cost, a variable operation and maintenance cost, a startup cost impact, a fixed operation and maintenance cost, or a desired bid adder, or any other desired client input that may be related to any cost within the power plant.
13. The method of Clause 8, wherein the one or more performance parameters of the at least one performance model comprise at least one of the following: a load, a demand or requested plant electrical energy generation, an ambient condition of pressure or temperature, an overall power plant heat rate, or an overall power plant energy power output or electrical energy.
14. The method of Clause 8, wherein the at least one dataset of the power plant capabilities in the future is displayed in graphical form or format.
15. An apparatus for assessing future power plant capabilities, comprising:
   a processor operable to store computer-executable instructions;
   a power plant assessment module comprising computer-executable instructions operable to:
      store one or more power plant historic operation parameters;
      store one or more power plant intrinsic performance capabilities based at least in part on an as-built configuration;
      store at least one client input;
      receive at least one power plant performance model based at least in part on one or more performance parameters of similar power plants or the one or more power plant historic operation parameters; and
      output power plant capabilities in the future based at least in part on the one or more power plant historic operation parameters, the one or more power plant intrinsic performance capabilities, the at least one client input, and the at least one power plant performance model.
16. The apparatus of Clause 15, wherein the at least one dataset of the power plant capabilities in the future is adjusted based on at least one of the following: an expected range of temperatures in the future, historic operational references of the power plant, maintenance planned for the power plant in the future, or existing or available power plant performance enhancements.
17. The apparatus of Clause 15, wherein the one or more power plant historic operation parameters comprise at least one of the following: generator output of electrical energy, a fuel flow, a combustion exhaust temperature, a steam input flow, a steam output flow, a condenser pressure, a steam generator drum pressure and temperature, a stack exit temperature, any collection of power plant auxiliary load(s), or an output from instrumentation installed at any location within the power plant.
18. The apparatus of Clause 15, wherein the one or more power plant intrinsic capabilities comprise at least one of the following: a power plant overall output of electrical energy, or a heat rate or ratio of thermal energy brought into the power plant over the electrical energy generated by the power plant over the same range of capable operation.
19. The apparatus of Clause 15, wherein the at least one client input comprises at least one of the following: a fuel price, an emission cost, a variable operation and maintenance cost, a startup cost impact, a fixed operation and maintenance cost, or a desired bid adder, or any other desired client input that may be related to any cost within the power plant.
20. The apparatus of Clause 15, wherein the one or more performance parameters of the at least one performance model comprise at least one of the following: a load, a demand or requested plant electrical energy generation, an ambient condition of pressure or temperature, an overall power plant heat rate, or an overall power plant energy power output or electrical energy.

## Claims

1. A system (300) for assessing future power plant (330) capabilities, comprising:
a computer processor (304);
a user interface (314) in communication with the computer processor; and
a memory (302) in communication with the computer processor (304) operable to store computer-executable instructions operable to:
receive one or more power plant historic operation parameters (204);
receive one or more power plant intrinsic performance capabilities (206) based at least in part on an as-built configuration;
receive at least one client input (208);
receive at least one power plant performance model (210) based at least in part on one or more performance parameters of similar power plants or the one or more power plant historic operation parameters; and
output via the user interface (314) at least one dataset of the power plant capabilities in the future (202), wherein the at least one dataset of the power plant capabilities in the future is based at least in part on the one or more power plant historic operation parameters (204), the one or more power plant intrinsic performance capabilities (206), the at least one client input (208), and the at least one power plant performance model (210).

2. The system (300) of Claim 1, wherein the at least one dataset of the power plant (330) capabilities in the future (202) is adjusted based on at least one of the following: an expected range of temperatures in the future, historic operational references of the power plant (330), maintenance planned for the power plant in the future, or existing or available power plant performance enhancements.

3. The system (300) of either of Claim 1 or Claim 2, wherein the one or more power plant historic operation parameters comprise at least one of the following: generator (332) output of electrical energy, a fuel flow, a combustion exhaust temperature, a steam input flow, a steam output flow, a condenser pressure, a steam generator drum pressure and temperature, a stack exit temperature, any collection of power plant auxiliary load(s), or an output from instrumentation installed at any location within the power plant.

4. The system (300) of any preceding Claim, wherein the one or more power plant intrinsic capabilities (206) comprise at least one of the following: a power plant overall output of electrical energy, or a heat rate or ratio of thermal energy brought into the power plant over the electrical energy generated by the power plant over the same range of capable operation.

5. The system of any preceding Claim, wherein the at least one client input (208) comprises at least one of the following: a fuel price, an emission cost, a variable operation and maintenance cost, a startup cost impact, a fixed operation and maintenance cost, or a desired bid adder, or any other desired client input that may be related to any cost within the power plant (330).

6. The system of any preceding Claim, wherein the one or more performance parameters of the at least one performance model (210) comprise at least one of the following: a load, a demand or requested plant electrical energy generation, an ambient condition of pressure or temperature, an overall power plant heat rate, or an overall power plant energy power output or electrical energy.

7. The system of any preceding Claim, wherein the at least one dataset of the power plant (330) capabilities in the future is displayed in graphical form or format.

8. A method (400) for assessing future power plant (330) capabilities, the method comprising:
receiving (402) one or more power plant (330) historic operation parameters (204);
receiving (404) one or more power plant intrinsic performance capabilities (206) based at least in part on an as-built configuration;
receiving (406) at least one client input (208);
receiving (408) at least one power plant performance model (210) based at least in part on the one or more performance parameters of similar power plants or the one or more power plant historic operation parameters; and
outputting (410) via a user interface (314) at least one dataset of the power plant (330) capabilities in the future, wherein the at least one dataset of the power plant capabilities in the future is based at least in part on the one or more power plant historic operation parameters, the one or more power plant intrinsic performance capabilities, the at least one client input, and the at least one power plant performance model.

9. The method (400) of Claim 8, wherein the at least one dataset of the power plant capabilities in the future is adjusted (412) based on at least one of the following: an expected range of temperatures in the future, historic operational references of the power plant, maintenance planned for the power plant in the future, or existing or available power plant performance enhancements.

10. The method of either of Claim 8 or 9, wherein the one or more power plant (330) historic operation parameters (204) comprise at least one of the following: generator output of electrical energy, a fuel flow, a combustion exhaust temperature, a steam input flow, a steam output flow, a condenser pressure, a steam generator drum pressure and temperature, a stack exit temperature, any collection of power plant auxiliary load(s), or an output from instrumentation installed at any location within the power plant (330).

11. The method of any of Claims 8 to 10, wherein the one or more power plant (330) intrinsic capabilities (206) comprise at least one of the following: a power plant (330) overall output of electrical energy, or a heat rate or ratio of thermal energy brought into the power plant over the electrical energy generated by the power plant over the same range of capable operation.

12. The method of any of Claims 8 to 11, wherein the at least one client input (208) comprises at least one of the following: a fuel price, an emission cost, a variable operation and maintenance cost, a startup cost impact, a fixed operation and maintenance cost, or a desired bid adder, or any other desired client input that may be related to any cost within the power plant (330).

13. The method of any of Claims 8 to 12, wherein the one or more performance parameters of the at least one performance model (210) comprise at least one of the following: a load, a demand or requested plant electrical energy generation, an ambient condition of pressure or temperature, an overall power plant heat rate, or an overall power plant energy power output or electrical energy.

14. The method of any of Claims 8 to 13, wherein the at least one dataset of the power plant capabilities in the future is displayed in graphical form or format.

15. An apparatus (300) for assessing future power plant (330) capabilities, comprising:
a processor (304) operable to store computer-executable instructions;
a power plant assessment module comprising computer-executable instructions operable to:
store one or more power plant historic operation parameters (204);
store one or more power plant intrinsic performance capabilities (206) based at least in part on an as-built configuration;
store at least one client input (208);
receive at least one power plant performance model (210) based at least in part on one or more performance parameters of similar power plants or the one or more power plant historic operation parameters; and
output power plant capabilities in the future (202) based at least in part on the one or more power plant historic operation parameters (204), the one or more power plant intrinsic performance capabilities (206), the at least one client input (208), and the at least one power plant performance model (210).
